# EUROPEAN PATENT APPLICATION

(11) **EP 4 679 496 A1**
(43) Date of publication of application: **14.01.2026**
(21) Application number: 24188389.1
(22) Date of filing: 12.07.2024
(51) Int. Cl.: H01L 21/673

(54) **APPARATUS AND METHOD FOR NON-IMMERSIVE WET-CHEMICAL TREATMENT OF A SUBSTRATE AND DEVICE FOR HOLDING THE SUBSTRATE**

(71) Applicant: Atotech Deutschland GmbH & Co. KG, 10553 Berlin (DE)
(72) Inventor: WEINHOLD, Ray, 10553 Berlin (DE); ALLINGER, Matthias, 10553 Berlin (DE); GAUL, Florian, 10553 Berlin (DE); KOHLER, Phillip, 10553 Berlin (DE)
(74) Representative: MKS IP Association

(57) **Abstract**

A device for holding at least one planar substrate (1,2) in an apparatus for non-immersive wet-chemical treatment of the substrate (1,2) comprises a pair of flow guide surfaces (23,24;50,51;88,89) on opposite sides of a space (28;55;93) for accommodating an edge region of at least one substrate (1). The flow guide surfaces (23,24;50,51;88,89) extend in a first direction (-z) to respective edges (25,26;52,53;90,91) and extend in a second direction (y) transverse to the first direction (-z). Each of the edges (25,26;52,53;90,91) bounds a gap (27;54;92) for insertion of an edge region of at least one substrate (1) into the space (28;55;93). A dimension of the space (28;55;93) in a third direction (x) transverse to the first and second directions (-z,y) decreases in the first direction (-z) over at least part of an extent in the first direction (-z) of the space (28;55;93). The device comprises at least one first array (15;44;76) of protruding engagement features and at least one second array (16;45;77) of protruding engagement features, protruding towards each other from first and second engagement feature supports (19;20;47;49;81;84), respectively. The first and second arrays (15,16;44,45;76,77) extend in the second direction (y). The engagement feature supports (19;20;47;49;81;84) are at least partially movable with respect to each other to move the first and second arrays (15,16;44,45;76,77) in the third direction (x). The protruding engagement features are located in the space (28;55;93) at a distance from the edges (25,26;52,53;90,91) in opposite direction (*z*) to the first direction (-*z*). The space (28;55;93) is accessible to liquid at a distance from the edges (25,26;52,53;90,91) in opposite direction *(z)* to the first direction (-*z*).

## Description

### Technical Field

The invention relates to a device for holding at least one planar substrate in an apparatus for non-immersive wet-chemical treatment of the substrate, comprising:
a pair of flow guide surfaces on opposite sides of a space for accommodating an edge region of at least one substrate,
wherein the flow guide surfaces extend in a first direction to respective edges and extend in a second direction transverse to the first direction, and
wherein each of the edges bounds a gap for insertion of an edge region of at least one substrate into the space, and
wherein a dimension of the space in a third direction transverse to the first and second directions decreases in the first direction over at least part of an extent in the first direction of the space; and
at least one first array of protruding engagement features and at least one second array of protruding engagement features, protruding towards each other from first and second engagement feature supports, respectively,
wherein the first and second arrays extend in the second direction, and
wherein the engagement feature supports are at least partially movable with respect to each other to move the first and second arrays in the third direction.

The invention also relates to an apparatus for non-immersive wet-chemical treatment of at least one planar substrate.

The invention also relates to a method of non-immersive wet-chemical treatment of at least one planar substrate.

### Backaround Art

WO 2024/046870 A1 discloses a substrate holding device comprising a support structure in the form of a frame surrounding the substrate on all sides, seen perpendicularly to the major surfaces of the substrate. The substrate holding device comprises first and second upper flow guidance parts and first and second lower flow guidance parts. The first and second upper flow guidance parts form the respective arms of an upper clamping device for clamping the substrate close to an upper edge of the substrate. The first upper flow guidance part is pivotably attached to the support structure by means of projecting upper pivot stubs defining a pivot axis parallel to the plane in which the substrate is held. Upper biasing devices urge the first upper flow guidance part towards the second upper flow guidance part and exert a clamping force. The first upper flow guidance part has an inward-facing surface facing inwards and an outward-facing surface facing outwards with respect to the plane in which the substrate is arranged to be held, in use. The inward-facing surface comprises a strip for engaging a major surface of the substrate without interruptions over the entire longitudinal extent of the strip. Similarly, the second upper flow guidance part has an inward-facing surface facing inwards and an outward-facing surface facing outwards with respect to the plane in which the substrate is arranged to be held, in use. The inward-facing surface also comprises a strip for engaging a major surface of the substrate without interruptions over the entire longitudinal extent of the strip. In use, processing liquid is directed onto an upper outward-facing surface section of one of the first and second upper flow guidance parts and from there flows as an equalised film flow over a lower outward-facing surface section onto the major surface of the substrate. The same is the case for the opposite side. Liquid cannot reach the edge region of the substrate above the level at which the strips engage the major surfaces.

An alternative panel holder currently in use holds the panel to be treated by means of discrete pins arranged below a lower edge of flow guidance parts that direct a film flow onto the panel on either side of the panel. These pins, however, give rise to eddies, i.e. turbulent flow. When the treatment is electroless plating, the result is non-uniform plating in the region of the panel where the panel is held by the pins. This undesirable phenomenon is called "skip plating".

US 10,513,779 B2 discloses a surface treating system. In this system, a substrate held by clips of a hanger undergoes surface treatment in sequence in a first cleaning section, a desmear section, a second cleaning section, a pretreatment section, a third cleaning section, an electroless copper plating section and a fourth cleaning section. The substrate is pinched and held at an upper end by clips of a hanger. On both sides of the substrate held by the hanger, pipes as treatment solution releasing sections are provided. The discharged treatment solution flows down the surfaces of the substrate and reaches the bottom, and is circulated and discharged from the pipes again by a pump. The hanger includes a top plate, hanging plates extending downward from the top plate, and a clip holding member fixed to the hanging plates. The clip is biased by a spring in such a direction that the tips of the clip are closed. Treatment solution receiving members extending along the entire width of the hanger are provided across the tips of the clips. Each treatment solution receiving member has a flat plate forming a proximal portion thereof and a projected section raised in a semi-circular shape to form a distal portion thereof. Gripping projections for pinching and grasping the substrate are provided along an inner lower end of each projected section. Adhesion prevention projections are also provided between the gripping projections. Flow guides may be provided to ensure that the treatment solution flows towards the substrate. Because the treatment solution flowing onto the substrate also slightly spreads upward in the vicinity of the lower ends of the projected sections, the treatment solution also reaches up to the upper end of the substrate. Thus, the treatment solution flows over the outward-facing surface of each projected section up to the lower edge of the projected section. There, most of the solution flows downwards onto the substrate. Some of the solution flows around the lower edge of the projected section into the gap between the substrate and the inward-facing surface of the treatment solution receiving member. This flow is between the adhesion prevention projections and the gripping projections. The splitting of the flow in upwards and downwards direction is also liable to give rise to eddies. Furthermore, the treatment solution between the inward-facing surface of the treatment solution receiving member and the substrate is refreshed at a lower rate than the solution flowing down the substrate. There is thus a non-uniform flow field in the region near the top edge of the substrate.

It is an object of the invention to provide a device, apparatus and method of the types mentioned above in the opening paragraphs that provide for a relatively uniform flow field in the region adjacent the edge of the substrate where the substrate is clamped by the engagement features.

This object is achieved according to a first aspect by the device according to the invention, which is characterised in that the protruding engagement features are located in the space at a distance from the edges in opposite direction to the first direction, and in that the space is accessible to liquid at a distance from the edges in opposite direction to the first direction.

The device is suitable for providing a film flow in the first direction across at least one, e.g. both, major surfaces of the or each planar substrate. Thus, in use, the first direction will be a downward direction generally parallel to the vertical. The second direction is parallel to the width of the substrate, seen looking onto a major surface of the substrate. The dimension of the gap in the third direction is at least equal to the thickness of one substrate. Thus, the first, second and third directions are parallel to respective axes of a three-dimensional cartesian co-ordinate system.

The pair of flow guide surfaces may each comprises a plurality of planar surface sections with different respective orientations or be curved. The flow guide surfaces extend in the first direction, but not parallel to the first direction along their entire extent in the first direction. For uniformity of flow, the flow guide surfaces may be parallel to the second direction everywhere, however. They terminate at the edges, between which a gap is defined. In use, liquid flows only in the first direction through the gap, and the flow detaches at the edges to be directed onto the major surfaces of the substrate inserted through the gap.

Each of the edges bounds the gap, but the gap need not be bounded on all sides to form a slot. The gap may be unbounded at opposite ends in the second direction.

Because a dimension of the space in a third direction transverse to the first and second directions decreases in the first direction over at least part of an extent in the first direction of the space, flow in the first direction is constricted and liquid, when supplied at a sufficient rate, can back up in opposite direction to the first direction to fill the space, in use. The protruding engagement features are located in the space at a distance from the edges in opposite direction to the first direction. The engagement features of the first and second arrays may in particular be located in the space at a distance in opposite direction to the first direction from where the dimension of the space in third direction has decreased to an at least local minimum. Generally, this minimum will correspond to a dimension in the third direction of the gap between the edges. Thus, the engagement features are submerged in processing liquid, in use. The surface of the edge region around the points of contact is in relatively uniform contact with the processing liquid. Skip plating and eddies are largely or completely avoided.

There is at least one first array of protruding engagement features and at least one second array of protruding engagement features, protruding towards each other from first and second engagement feature supports, respectively, wherein the first and second arrays extend in the second direction. Liquid can thus flow around and between the engagement features. The major surfaces of the substrate can contact the processing liquid up to the edge.

The space is accessible to liquid at a distance from the edges in opposite direction to the first direction. The space may be accessible to liquid at a distance from the first and second arrays in opposite direction to the first direction. Accessible means that the liquid can enter the space at that level. Due to the accessibility the device is configured for the liquid to flow in the first direction between the flow guide surfaces, and then out of the space through the gap, rather than in the other direction. The flow of liquid is thus everywhere in downward direction.

In an embodiment, the edges are straight edges.

This results in a film flow across the major surfaces of the planar substrate that is relatively uniform in the second direction. It is also relatively easy to manufacture relatively sharp edges. The edges will generally extend in parallel to the second direction in this embodiment.

In an embodiment of the device, the flow guide surfaces and the edges are formed on at least one body.

In this embodiment, at least surface sections of the at least one body extending to the edges may be formed by machining.

Machining need not be the only operation by means of which the bodies are manufactured. The machining operation may be applied to a pre-form, e.g. a pre-form obtained by moulding, additive manufacturing, spark eroding or a combination thereof. Machining is a useful technique for producing sharp edges.

In an embodiment of the device, a respective undercut is formed adjacent at least one of the edges on an opposite side in the first direction of the edge with respect to the flow guide surface extending to the edge.

This promotes detachment of the flow of liquid at the edges, so that the liquid flows relatively uniformly onto the major surfaces of the substrate inserted through the gap. There are relatively few eddies at the edges.

In an embodiment, the space is closed, e.g. bounded by walls, at opposite ends in the second direction.

The walls may each comprise one or more plates. In particular, a pair of plates may abut in the third direction to form one of the boundaries of the space in the second direction. An effect is to ensure that liquid can only flow out through the gap. The flow of liquid is therefore uniformly directed in only the first direction. Furthermore, the speed of flow is lower, giving rise to a laminar flow through the gap. This further contributes towards uniform treatment of the edge region.

An embodiment of the device further comprises at least one collecting space, bounded on at least opposite sides in the third direction by dam wall surfaces extending in the first and second directions, wherein the space for accommodating the edge region of at least one substrate is located between the edges and the collecting space in the first direction, and wherein the collecting space comprises at least one liquid outlet opening in communication with the space for accommodating the edge region of at least one substrate and at least one liquid inlet opening distal to the liquid outlet opening in opposite direction to the first direction.

The collecting space serves to collect liquid supplied to the device from an external source, e.g. a liquid supply system in a station of the apparatus for non-immersive wet-chemical treatment. In use, the collecting space is located at a higher level than the space for accommodating the edge region of at least one substrate. The collecting space serves as a buffer, smoothing out supply pressure fluctuations. Also, the space for accommodating the edge region of at least one substrate may be completely filled with liquid in use, the free liquid surface being located in the collecting space. There may be more than one collecting space, e.g. a row of collecting spaces extending in the second direction. The one or more collecting spaces may, for example, extend over the extent in the second direction of the space for accommodating the edge region of at least one substrate. In an example hereof, the collecting space, or those collecting spaces at the limits of the extent in the second direction of the space for accommodating the edge region of at least one substrate, is or are closed at those limits, e.g. bounded by walls. These may be the same walls as those closing the space for accommodating the edge region of at least one substrate.

An embodiment of the device further comprises at least one flow distributor having at least one channel formed therein, wherein the channels extend in the first direction, and wherein the channels open into the space for accommodating the edge region of at least one substrate.

The flow distributor device promotes uniformity of flow, minimising variations of flow parameters (e.g. pressure, velocity) in the second direction.

In an example of any embodiment further comprising at least one flow distributor having at least one channel formed therein, wherein the channels extend in the first direction, and wherein the channels open into the space for accommodating the edge region of at least one substrate, the channels comprise a plurality of discrete, e.g. straight channels.

The channels may have a smaller extent in the first direction than in at least one of the other directions, so that they could also be regarded as apertures. Straight channels, e.g. having a constant cross-section over their extent in the first direction, are relatively easy to manufacture. They can be drilled into a plate, for example. For a sufficient volumetric flow rate and sufficient uniformity of flow, however, there must be relatively many of such channels.

Thus, an example of any embodiment further comprising at least one flow distributor having at least one channel formed therein, wherein the channels extend in the first direction, and wherein the channels open into the space for accommodating the edge region of at least one substrate, the channels comprise at least one channel open at opposite ends of the channel in the first direction and having a shape meandering in the second direction.

The meandering channel(s) may extend in the second direction over a majority, e.g. all of the extent in the second direction of the space for accommodating the edge region of at least one substrate.

An embodiment of the device further comprises at least one biasing device, e.g. comprising at least one resilient element, for urging the first and second engagement feature supports towards each other in the third direction.

This embodiment maintains a clamping force without external power supply. The biasing device(s) need not act directly onto the engagement feature supports. They may, for example, do so through one or more linkages.

In an embodiment of the device, the flow guide surfaces are formed on respective first and second bodies, and at least one of the first and second feature supports corresponds to a respective one of the first and second bodies.

This embodiment can be relatively compact, because there is no need to provide space for mounting the engagement feature supports between the flow guide surfaces. Such separate engagement feature supports might otherwise also adversely affect the uniformity of flow through the space for accommodating the edge region of at least one substrate.

In an example of this embodiment, the engagement features protruding from the engagement feature support forming a respective one of the first and second bodies each comprise a section of a respective pin fixed to that body.

This embodiment is relatively easy to manufacture with relatively many discrete engagement features. Machining to form engagement features integral to a body made in one piece would, for example, be more complicated.

In an example of any embodiment in which the flow guide surfaces are formed on respective first and second bodies, and at least one of the first and second feature supports corresponds to a respective one of the first and second bodies, the engagement features protruding from the engagement feature support forming a respective one of the first and second bodies protrude from the flow guide surface formed on that body.

An embodiment of the device further comprises a support structure comprising at least one part for engaging an external support to position the device in the apparatus for non-immersive wet-chemical treatment of the substrate.

In this embodiment, the device with the substrate or substrate mounted thereto can be conveyed from station to station within the apparatus for non-immersive wet-chemical treatment of the substrate(s). The substrate(s) need only be mounted once. It is relatively easy to avoid damage to the substrate(s), because only the device holding the substrate(s) is handled directly.

In an example of this embodiment, at least one of the first and second engagement feature supports is journalled to the support structure.

In particular, at least one of the first and second engagement feature may be pivotably mounted to the support structure, e.g. with a pivot axis extending in parallel to the second direction.

In an example of any embodiment in which the device further comprises a support structure comprising at least one part for engaging an external support to position the device in the apparatus for non-immersive wet-chemical treatment of the substrate, the support structure comprises a frame, arranged to frame at least a central section of a major surface of the substrate, seen in the third direction.

In this embodiment, the support structure can support clamping devices for holding the substrate(s) at further edge regions. This makes the device suitable for holding relatively flexible substrates. Furthermore, the frame provides a measure of protection.

An example of this embodiment further comprises at least one clamping device for clamping at least one of the at least one substrates at an edge of that substrate opposite an edge of that substrate proximal to the edge region of that substrate.

This example is well-suited to flexible substrates. The film flow is maintained up to the (in use) lower edge, i.e. the opposite edge referred to. Fluttering or curvature of the substrate is minimised.

In an example of any embodiment in which the device further comprises a support structure comprising at least one part for engaging an external support to position the device in the apparatus for non-immersive wet-chemical treatment of the substrate, and the support structure comprises a frame, arranged to frame at least a central section of a major surface of the substrate, seen in the third direction, the device further comprises at least one of at least one caster and at least one skid for movably supporting the device on a support surface.

An embodiment of the device further comprises at least one flow guidance part comprising an outward-facing surface section wettable by a jet of liquid directed onto the outward-facing surface section and extending towards an edge proximal to the space for accommodating the edge region of at least one substrate, and at least one part defining a wall bounding a space for collecting liquid detaching itself from the outward-facing surface section at the proximal edge, which space for collecting liquid is at least in liquid communication with the space for accommodating the edge region of at least one substrate.

This embodiment provides an easy way of supplying processing liquid to the space for accommodating the edge region of at least one substrate from an external source, e.g. a liquid supply system in a station of the apparatus for non-immersive wet-chemical treatment. There is no need to connect a tube or hose to the device for holding at least one planar substrate. The term jet is used here in these sense of being a coherent stream of liquid projected into a surrounding medium, in this case the atmosphere surrounding the device, usually from some kind of a nozzle or aperture. The stream is unguided on entering the medium.

An embodiment of the device further comprises a third array of protruding engagement features and a fourth array of protruding engagement features, protruding towards each other from respective engagement feature supports, wherein each of the third and fourth arrays extends in the second direction, and wherein the engagement feature supports are at least partially movable with respect to each other to move the third and fourth arrays in the third direction, wherein the engagement features of the third and fourth arrays are one of:
(i) located in the space for accommodating the edge region of at least one substrate at a distance from the edges in opposite direction to the first direction, and
(ii) located in a second space for accommodating the edge region of at least one substrate,

wherein a second pair of second flow guide surfaces is provided on opposite sides of the second space,
wherein the second flow guide surfaces extend in the first direction to respective second edges and extend in the second direction, and
wherein each of the second edges bounds a second gap for insertion of an edge region of at least one substrate into the second space, and
wherein a dimension of the second space in the third direction decreases in the first direction over at least part of an extent in the first direction of the second space,
wherein the protruding engagement features of the third and fourth arrays are located in the second space at a distance from the second edges in opposite direction to the first direction, and
wherein the second space is accessible to liquid at a distance from the second edges in opposite direction to the first direction.

The second space will generally be located next to the space for accommodating the edge region of at least one substrate in the third direction. In this embodiment, at least one major surface of each of two substrates can undergo non-immersive wet-chemical treatment simultaneously. The substrates are held in parallel arrangement with facing major surfaces. Because the flow of liquid is only out of the space and second space and through the gap and second gap onto the substrate and further substrate, there is no flow in the opposite direction. Thus, the fact that each of the substrates has one major surface facing a major surface of the other substrate need not lead to a difference in treatment between the two major surfaces of any one substrate.

In an example of this embodiment, one of the third array of protruding engagement features and the fourth array of protruding engagement features protrudes from one of the first and second engagement feature supports in an opposite direction to the engagement features of that one of the first and second arrays protruding from that one of the first and second engagement feature supports.

This embodiment is relatively compact in the third direction.

As is the case for the space for the space for accommodating the edge region of at least one substrate, the further space may also be closed, e.g. bounded by walls, at opposite ends in the second direction.

According to another aspect, the invention provides an apparatus for non-immersive wet-chemical treatment of at least one planar substrate, comprising:
at least one treatment station;
at least one device according to the invention;
at least one support to hold the device in the treatment station; and
at least one liquid supply system for supplying liquid to the space for accommodating the edge region of at least one substrate in at least the treatment station.

An embodiment of the apparatus comprises a conveying system for conveying the device for holding at least one planar substrate through the apparatus, wherein the liquid supply system is stationary with respect to the apparatus.

The device for holding at least one planar substrate may be transferred between supports in successive stations of the apparatus or may be comprised in the conveying system, e.g. mounted to a movable support driven through the stations.

In an example of this embodiment, the device for holding at least one planar substrate is a device further comprising at least one flow guidance part comprising an outward-facing surface section wettable by a jet of liquid directed onto the outward-facing surface section and extending towards an edge proximal to the space for accommodating the edge region of at least one substrate, and at least one part defining a wall bounding a space for collecting liquid detaching itself from the outward-facing surface section at the proximal edge, which space for collecting liquid is at least in liquid communication with the space for accommodating the edge region of at least one substrate, wherein the liquid supply system comprises a system for directing a jet of liquid from an orifice onto the outward-facing surface section of the flow guidance part.

According to another aspect, the invention provides a method of non-immersive wet-chemical treatment of a planar substrate, e.g. in an apparatus according to the invention, comprising:
mounting the substrate to a device according to the invention, and
supplying processing liquid to the space for accommodating an edge region of at least one substrate.

### Brief Description of Drawings

The invention will be explained in further detail with reference to the accompanying drawings, in which:
- Fig. 1: is a perspective view of a first substrate holding device holding a substrate;
- Fig. 2: is a plan view of the first substrate holding device holding the substrate;
- Fig. 3: is a perspective view of the first substrate holding device without the substrate;
- Fig. 4: is a perspective view of a lower clamping device of the first substrate holding device;
- Fig. 5: is a first perspective view of an upper section of the first substrate holding device;
- Fig. 6: is a second perspective view of the upper section of the first substrate holding device;
- Fig. 7: is a perspective view of selected parts of the upper section of the first substrate holding device;
- Fig. 8: is an end view of selected parts of the upper section of the first substrate holding device;
- Fig. 9: is an orthogonal projection corresponding to the end view of Fig. 8;
- Fig. 10: is a perspective view of selected part of the upper section of a variant of the first substrate holding device;
- Fig. 11: is a first perspective view of parts of an upper section of a second substrate holding device;
- Fig. 12: is a second perspective view of parts of the upper section of the second substrate holding device;
- Fig. 13: is a third perspective view of selected part of the upper section of the second substrate holding device;
- Fig. 14: is an end view of selected parts of the supper section of the second substrate holding device;
- Fig. 15: is an orthogonal projection corresponding to the end view of Fig. 14;
- Fig. 16: is a perspective view of third substrate holding device and two substrates;
- Fig. 17: is a perspective view of a lower clamping device of the third substrate holding device;
- Fig. 18: is a first perspective view of an upper section of the third substrate holding device and the two substrates;
- Fig. 19: is a second perspective view of the upper section of the third substrate holding device and the two substrates;
- Fig. 20: is a perspective view of the third substrate holding device without the substrates;
- Fig. 21: is a perspective view of the lower clamping device of the third substrate holding device without the substrate;
- Fig. 22: is a perspective view of the upper section of the third substrate holding device without the substrates;
- Fig. 23: is a first perspective view of selected parts of the upper section of the third substrate holding device;
- Fig. 24: is a second perspective view of selected parts of the upper section of the third substrate holding device;
- Fig. 25: is an end view in orthogonal projection of the parts shown in Fig. 24.

### Description of Embodiments

In the following, various examples of devices for holding one or more planar substrates 1,2 in an apparatus for non-immersive wet-chemical treatment of the substrates 1,2 will be described. Instead of being immersed in a bath of processing liquid, the substrate 1,2 is wetted on at least one side by processing liquid that flows across one or both major surfaces of the substrate 12 in the form of a relatively thin film of liquid. This reduces the amount of processing liquid that is needed, providing environmental and economic benefits. The treatment may comprise rinsing, de-smearing, etching, swelling, reduction or plating, including in particular electrodeless plating, for example. The apparatus may comprise multiple treatment stations, each configured to treat the substrate 1,2 with a particular liquid.

The substrate 1,2 is mounted to the device for holding one or more substrates 1,2 during the treatment in at least one of the stations. To this end, the device for holding one or more substrates 1,2 is held in the station by a support (not shown). The support is configured to hold the device in such an orientation that the substrate plane is at least at an acute angle to the vertical, e.g. parallel to within 5° to the vertical, so that the liquid can flow down across the major surface or surfaces of the planar substrate 1,2.

Although the substrate 1,2 is referred to as planar, the substrate 1,2 may be flexible, e.g. a foil. The devices to be described in more detail below are suitable in particular for such substrates 1,2 as printed circuit board, semiconductor dies or integrated circuit substrates and the like. The substrate 1,2 is at least planar when mounted to the device for holding the substrate 1,2. In the examples to be discussed below, the substrates 1,2 are quadrilateral, e.g. square, seen looking onto their major surfaces. They may alternatively have a different polygonal, or even round, shape. A shape defining a straight edge at which the substrate 1,2 can be held is most suitable.

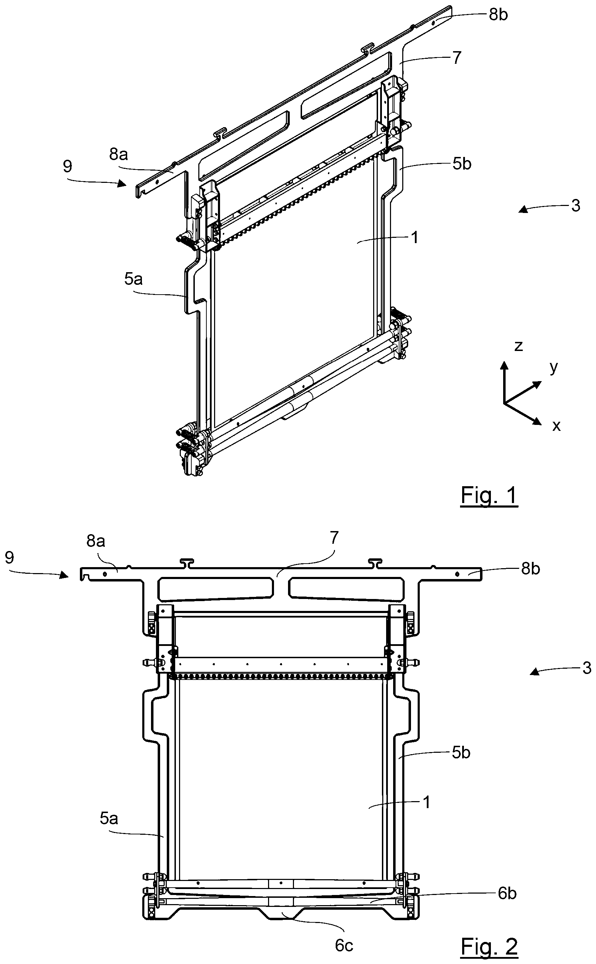

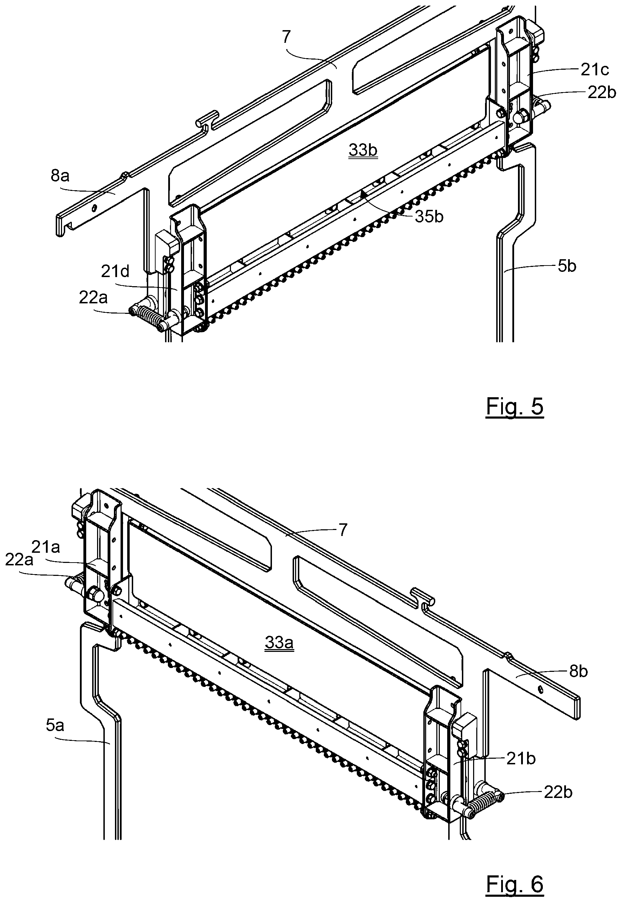

A first substrate holding device 3 (Figs. 1-9) comprises a support structure for engaging an external support to position the first substrate holding device 3 in an apparatus (not shown) for non-immersive wet-chemical treatment of the substrate 1. In this example, the support structure comprises a frame 4 arranged to frame at least a central section of a major surface of the substrate 1, seen looking on to the major surface. In the illustrated first substrate holding device 3, the frame frames the complete major surface of the substrate 1.

The frame 4 comprises at least lateral members 5a,b, lower members 6a-c and an upper member 7. The upper member 7 comprises laterally projecting arms 8a,b for engaging supports (not shown), so as to suspend the first substrate holding device 3 in a treatment station of the treatment apparatus. A claw 9 for engaging a horizontally extending pin of the support is defined at a distal end of at least one of the arms 8a,b. Examples of a suitable support are disclosed in WO 2020/260389 A1.

The configuration of the support structure is such as to allow the first substrate holding device 3 to be conveyed from station to station in the treatment apparatus. To this end, the external support may either be comprised in a transporter of a conveying system (not shown) or the conveying station may be configured to transfer the first substrate holding device 3 between supports provided in respective treatment stations. At least one of the lower members 6a-d may be provided with one of at least one skid and at least one caster (not shown) for movably supporting the first substrate holding device 3 on a support surface.

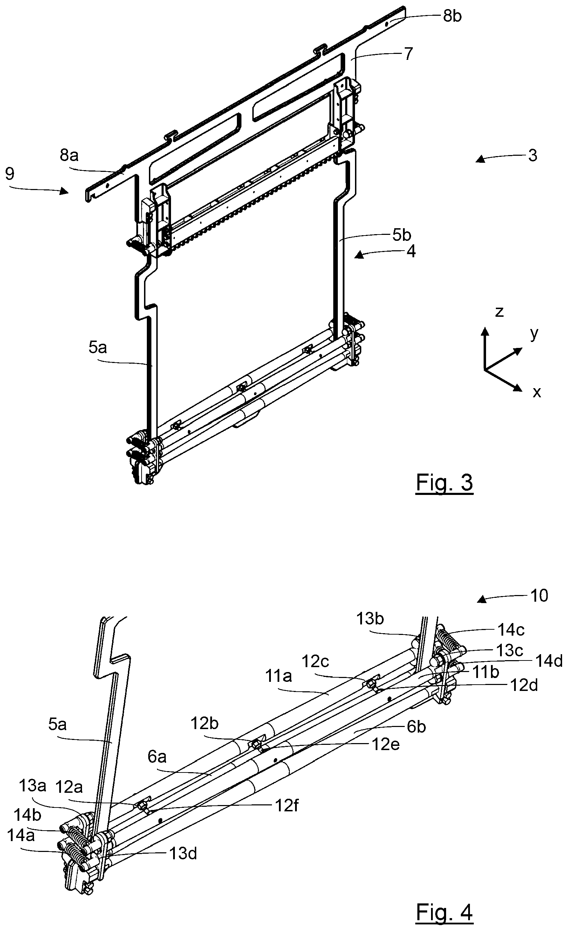

It is convenient to define a co-ordinate system (Figs. 1 and 3) with reference to the substrate 1 when mounted to the first substrate holding device 3 with an orientation permitting the non-immersive wet-chemical treatment to be carried out. In that situation, the major surfaces of the planar substrate 1 are in a plane parallel to a first direction -*z* and a second direction *y.* They face in directions aligned with a third direction x. In the orientation permitting non-immersive wet-chemical treatment to be carried out, the first direction -*z* is essentially parallel to the vertical, i.e. the planar substrate 1 has an upright orientation, so that liquid can flow down the major surfaces of the substrate 1 as a gravity-driven film flow.

The first substrate holding device 3 comprises an upper clamping device (described in more detail below) and a lower clamping device 10 (Fig. 4).

The lower clamping device 10 comprises a pair of support bars 11a,b on which protruding lower engagement features 12a-f are mounted. The lower engagement features 12a-f provided on one of the support bars 11a,b protrude towards the other one of the support bars 11a,b and *vice versa.* The lower engagement features 12a-f are configured to engage the opposite major surfaces of the planar substrate 1 at an (in use lower) edge of the planar substrate 1. To this end, the support bars 11a,b are mounted on pivotable lower support levers 13a-d. Biasing devices comprising resilient elements, in this case lower coil springs 14a-d are provided to urge the support bars 11a,b towards each other in the third direction *x*. Cams (not shown in detail) or other features may be defined on the lower support levers 13a-d to apply a force moving the support bars 11 apart in the third direction *x* to release the substrate 1. Other types of biasing device may be used, e.g. other types of elastic element, gas springs or magnets.

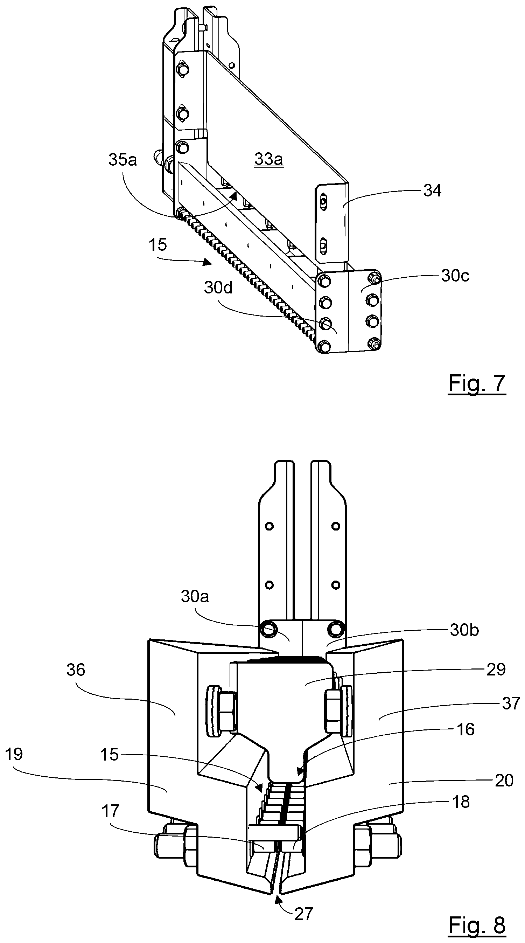

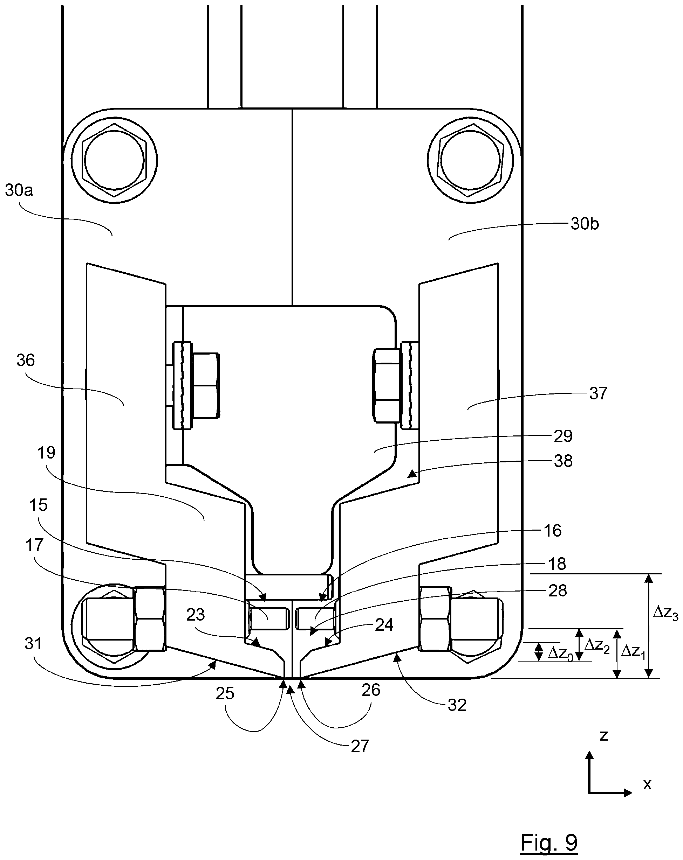

The upper clamping device for clamping the substrate 1 in an edge region close to an, in use upper, edge of the substrate 1 comprise a first array 15 of engagement features and a second array 16 of engagement features (Figs. 8, 9). The first array 15 and second array 16 extend in the second direction *y*. The engagement features of each array 15,16 are discrete features spaced apart in the second direction *y*. They protrude in directions corresponding to the third direction *x*, so that liquid can pass in the third direction -z between adjacent engagement features.

In the illustrated first substrate holding device 3, the engagement features of the first and second arrays 15,16 are in each case arranged in a single straight line. Alternatively, one or both of the arrays 15,16 may comprise multiple rows of engagement features, each row extending in the second direction *y*, with the rows spaced apart in the first direction *z*. The arrays, in the case of the alternative example the rows, may extend in non-straight, e.g. curved lines, e.g. if the edge region adjoins a curved substrate edge.

In the illustrated first substrate holding device 3, the engagement features of the first array 15 are formed by first pins 17 mounted to a first body 19. The engagement features of the second array 16 are formed by second pins 18 mounted to a second body 20. In the illustrated first substrate holding device 3, the first and second pins 17,18 are provided with threads, mounted in respective bores or other through-going passages in the first and second body 19,20 and secured by first and second nuts. Other means of securing the first and second pins 17,18 may be used instead.

The first and second bodies 19,20 are mounted to pivotable upper support levers 21a-d, which are pivotably mounted to the support structure of the first substrate holding device 3. In this example, they are pivotably mounted to the upper member 7 of the frame 4. The pivot axes extend in the second direction *y*. Biasing devices comprising resilient elements, in this example upper coil springs 22a,b, are provided to urge the first and second arrays 15,16 towards each other in a direction corresponding to the third direction *x*. These resilient elements thus provide the clamping force. In a variant, other types of biasing device may be used, e.g. comprising at least one gas spring or at least one magnet.

In a variant, only one of the first and second bodies 19,20 is mounted to pivotable upper support levers 21 and the other is fixed to the support structure of the first substrate holding device 3. In another variant, the first and second bodies 19,20 or alternative supports carrying the first and second arrays 15,16, are themselves pivotably mounted to the support structure. In that case, they are thus only partially movable with respect each other, because their respective pivot axes are fixed in position.

The first body 19 presents an inward-facing surface comprising a first flow guide surface 23. The second body 20 presents an inward-facing surface comprising a second flow guide surface 24. These surfaces are non-planar, but they are oriented parallel to the second direction *y* everywhere and parallel to or at an angle smaller than 90° to the first direction -*z*. Thus, the first flow guide surface 23 and the second flow guide surface 24 each progress in the first direction *-z* up to a first edge 25 and a second edge 26, respectively.

There is a gap 27 between the first edge 25 and the second edge 26 through which an edge region of the substrate 1 can pass into a space 28 for accommodating the edge region. This space 28 is defined between at least sections of the inward-facing surfaces of the first and second bodies 19,20, such that the first flow guide surface 23 and the second flow guide surface 24 are located on opposite sides of the space 28.

In the illustrated first substrate holding device 3 (Fig. 9), the space 28 only extends in the first direction -*z* between a first position and a second position corresponding to the position of the edges 25,26 in the first direction -*z*. The first position corresponds to a position of a lower edge of each of a series of baffle plates 29 partially sub-dividing the larger space between the inward-facing surfaces of the bodies 19,20.

Going from the first position to the second position, the dimension in the third direction *x* of the space 28 decreases at least over an interval *Δz₀* in the first direction -z. A gravitational flow of liquid flowing the first direction -*z* thus faces a constriction there. The liquid will back up.

The engagement features of the first and second arrays 15,16 are located in the space 28 at a distance *Δz₁* in opposite direction *z* to the first direction -*z* from the edges 25,26. In particular, the engagement features of the first and second arrays 15,16 are located in the space 28 at a distance *Δz₂* in opposite direction *z* to the first direction -*z* from where the dimension of the space 28 in third direction *x* has decreased to an at least local minimum. Generally, this minimum will correspond to a dimension in the third direction *x* of the gap 27 between the edges 25,26, as in the illustrated example.

In the example of the first substrate holding device 3, the space 28 is accessible to liquid at a distance *Δz₃* from the edges 25,26 in opposite direction *z* to the first direction -*z* at least equal to the distance *Δz₁* in opposite direction *z* to the first direction -*z* between the first and second arrays 15,16 and the edges 25,26. In an alternative substrate holding device, liquid may enter the space 28 at a location closer to the edges 25,26, but at a distance in opposite direction *z* to the first direction -*z* from where the dimension of the space 28 in third direction *x* has decreased to an at least local minimum, since a gravitational flow of liquid will in any case then back up.

In the illustrated first substrate holding device 3, a gravity-driven flow of liquid can simply flow down between the first and second bodies 19,20.

Although not required, the space 28 and gap 27 are also bounded at at least one of two opposite ends in the second direction *y*. In the illustrated first substrate holding device 3, end plates 30a,b are provided to this end. This helps keep the first and second arrays 15,16 submerged, in use. As a consequence, the direction of flow is uniformly in the first direction -*z*. Furthermore, the speed of flow is lower, because liquid can only flow out through the gap 27. Due to these effects, there are fewer or no eddies in the region of the first and second arrays 15,16. In other word, the space 28 is closed laterally to form a tub, achieving uniformity of flow in the second direction *y*. The fill level in the tub is relatively uniform, which promotes the formation of a laminar flow out of the gap 27.

The edges 25,26 are relatively sharply defined, in order to ensure that the liquid flows out of the gap 27 and onto the major surfaces of the substrate 1 with relatively few eddies. The first flow guide surface 23 meets a first exterior surface 31 at an angle at the first edge 25. The second flow guide surface 24 meets a second exterior surface 32 at an angle at the second edge 26. The angle may be equal to or smaller than 90°, for example. It is also possible to provide an undercut at the edges 25,26 to promote detachment of the flow from the bodies 19,20 at the edges 25,26 .

To provide such sharp edges 25,26, the process of manufacturing the first and second bodies 19,20 may comprise a machining process. The first and second bodies 19,20 may be machined entirely from a respective block of material or the machining process may be applied to a pre-form, e.g. a pre-form obtained by moulding or additive manufacturing.

The first substrate holding device 3 is configured to be conveyed through the apparatus for wet-chemical treatment of the substrate 1. To facilitate this, systems for supplying processing liquid are stationary in the apparatus and configured to direct one or more jets (coherent streams of liquid projected into a surrounding medium, usually from some kind of a nozzle or aperture) onto or into the first substrate holding device 3. In the illustrated example, sheet-shaped jets of liquid can be projected from either side onto outward-facing surface sections 33a,b of a flow guidance part, in this case in the form of a flow guidance plate 34. The outward-facing surface sections 33a,b extend in the first direction -*z* to respective, in use lower, edges 35a,b proximal to the space 28. First and second dam wall sections 36,37 are defined by the first and second bodies 19,20 and bound collecting spaces 38 for collecting liquid detaching itself from the outward-facing surface sections 33a,b. The collecting spaces 38 are obviously in liquid communication with the space 28 for receiving the edge region of the substrate 1. There are multiple collecting spaces 38 due to the presence of the baffle plates 29 partially sub-dividing the larger space between the inward-facing surfaces of the bodies 19,20. In addition, the end plates 30a,b also bound the collecting spaces 38 at the opposite ends in the second direction y. Thus, the baffle plates 29 need not achieve complete partitioning for the effect of providing a uniform direction of flow in the first direction -*z* to be enhanced.

To supply the sheet-shaped jets of processing liquid, the stations of the apparatus for non-immersive wet-chemical treatment of the substrate 1 may comprise flooding devices of the type disclosed in WO 2024/046870 A1. These are configured to direct a downwardly-directed stream of liquid onto the outward-facing surface sections 33a,b. The dimension of the outward-facing surface sections 33a,b in the first direction -*z* is sufficient to establish a laminar flow at the edges 35a,b. Due to the fact that the liquid backs up from the first and second edges 25,26, this is not strictly required. However, it helps to limit splashing so that more or less all of the processing liquid also flows across the major surfaces of the substrate 1.

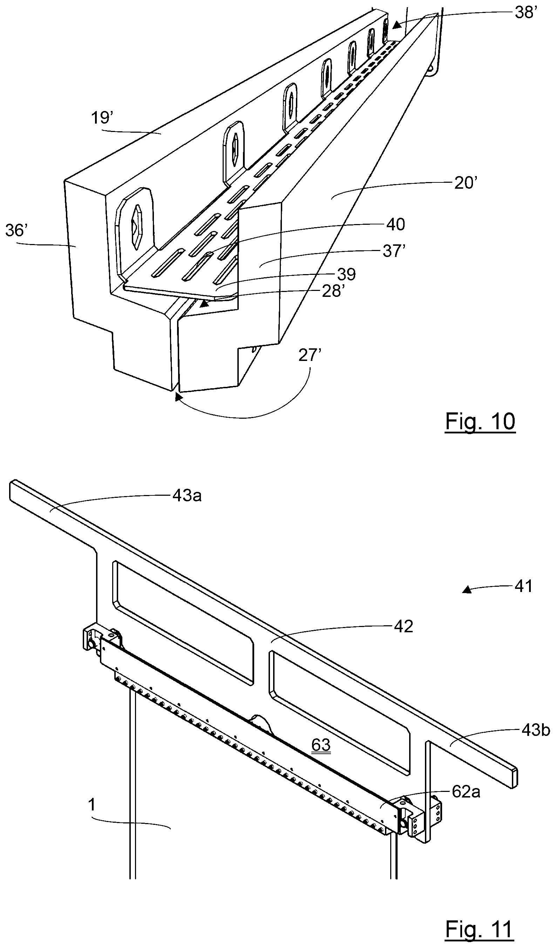

In a variant of the first substrate holding device 3 (Fig. 10), the baffle plates 29 are replaced by a flow distributor 39 separating the collecting space 38' from the space 28' for accommodating the edge region of the substrate 1. The flow distributor 39 is provided with apertures 40 forming channels extending in the first direction -*z*. These channels open into the space 28' for accommodating the edge region of the substrate 1. In the illustrated example, the apertures 40 are slit-shaped, having a longitudinal axis extending in the second direction *y*. Other shapes are possible.

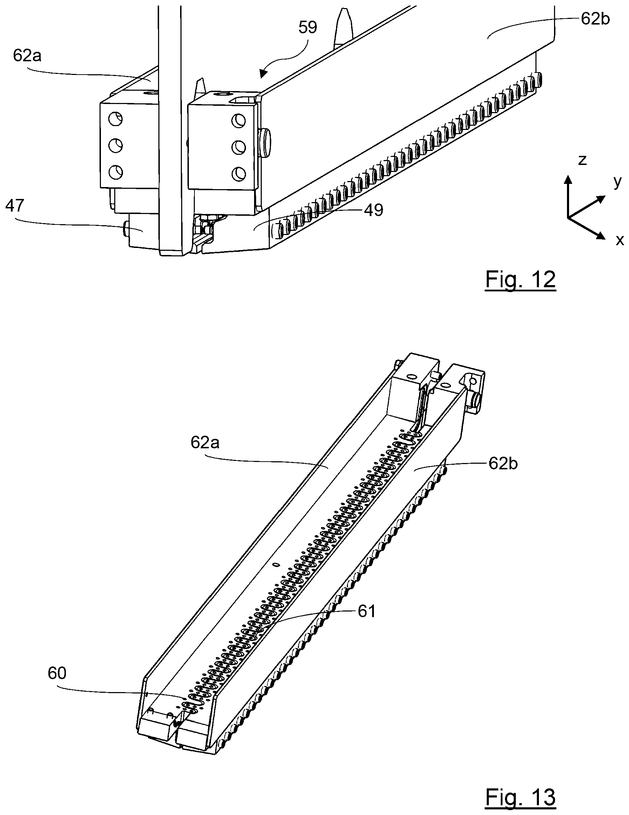

A second substrate holding device 41 (Figs. 11-15) is similar to the first substrate holding device 3, so that only selected parts of an upper section of the second substrate holding device 41 are shown. Otherwise, the description of the first substrate holding device 3, in particular insofar as the description relates to the frame 4 and the lower clamping device 10, also pertains to the second substrate holding device 41.

The support structure of the second substrate holding device 41 comprises a frame comprising an upper member 42. The upper member 42 comprises laterally projecting arms 43a,b for engaging supports (not shown), so as to suspend the second substrate holding device 41 in a treatment station of the treatment apparatus. In a variant, one or more claws similar to the claw 9 of the first substrate holding device 3 may be provided.

The configuration of the support structure is such as to allow the second substrate holding device 41 to be conveyed from station to station in the treatment apparatus. To this end, the external support may either be comprised in a transporter of a conveying system (not shown) or the conveying station may be configured to transfer the second substrate holding device 41 between supports provided in respective treatment stations.

The same co-ordinate system is defined with reference to the substrate 1 when mounted to the second substrate holding device 41 with an orientation permitting the non-immersive wet-chemical treatment to be carried out. In that situation, the major surfaces of the planar substrate 1 are in a plane parallel to a first direction -*z* and a second direction *y.* They face in directions aligned with a third direction *x*. In the orientation permitting non-immersive wet-chemical treatment to be carried, the first direction -*z* is essentially aligned with the vertical, i.e. the planar substrate 1 has an upright orientation, so that liquid can flow down the major surfaces of the substrate 1 as a film flow.

The second substrate holding device 41 comprises an upper clamping device and a lower clamping device (both not shown in all details).

The upper clamping device for clamping the substrate 1 in an edge region close to an, in use upper, edge of the substrate 1 comprises a first array 44 of engagement features and a second array 45 of engagement features. The first array 44 and second array 45 extend in the second direction y. The engagement features of each array 44,45 are discrete features spaced apart in the second direction y. They protrude in directions corresponding to the third direction *x*, so that liquid can pass in the third direction -z between adjacent engagement features.

In the illustrated second substrate holding device 41, the engagement features of the first and second arrays 44,45 are in each case arranged in a single straight line. Alternatively, one or both of the arrays 44,45 may comprise multiple rows of engagement features, each row extending in the second direction *y,* with the rows spaced apart in the first direction *z.* The arrays, in the case of the alternative example the rows, may extend in non-straight, e.g. curved lines, e.g. if the edge region adjoins a curved substrate edge.

In the illustrated second substrate holding device 41, the engagement features of the first array 44 are formed by first pins 46 mounted to a first body 47. The engagement features of the second array 45 are formed by second pins 48 mounted to a second body 49. The first and second pins 46,48 may be mounted in respective bores or other through-going passages in the first and second body 47,49, e.g. in the manner of the first and second pins 17,18 of the first substrate holding device 3.

The first and second bodies 47,49 are mounted to the upper member 42 such that the first and second bodies 47,49 are at least partially movable with respect to each other to move the first and second arrays 44,45 in the third direction *x*. They may be pivotably mounted to the upper member 42 or mounted to supports that are pivotably mounted to the upper member 42 of the frame comprised in the support structure, with the pivot axes in each case extending in the second direction *y*. As in the case of the first substrate holding device 3, resilient elements or other biasing devices may provide a force urging the first and second arrays 44,45 towards each other in the third direction *x*.

The first body 47 presents an inward-facing surface comprising a first flow guide surface 50. The second body 49 presents an inward-facing surface comprising a second flow guide surface 51. These surfaces are non-planar, but they are oriented parallel to the second direction *y* everywhere and parallel to or at an angle smaller than 90° to the first direction -*z*. Thus, the first flow guide surface 50 and the second flow guide surface 51 each progress in the first direction -*z* up to a first edge 52 and a second edge 53. There is a gap 54 between the first edge 52 and the second edge 53 through which an edge region of the substrate 1 can pass into a space 55 for accommodating the edge region. This space 55 is defined between at least sections of the inward-facing surfaces of the first and second bodies 47,49, such that the first flow guide surface 50 and the second flow guide surface 51 are located on opposite sides of the space 55.

The dimension in the third direction *x* of the space 55 decreases at least over an interval *Δz₀* in the first direction *-z.* A gravitational flow of liquid flowing the first direction -*z* thus faces a constriction there. The liquid will back up.

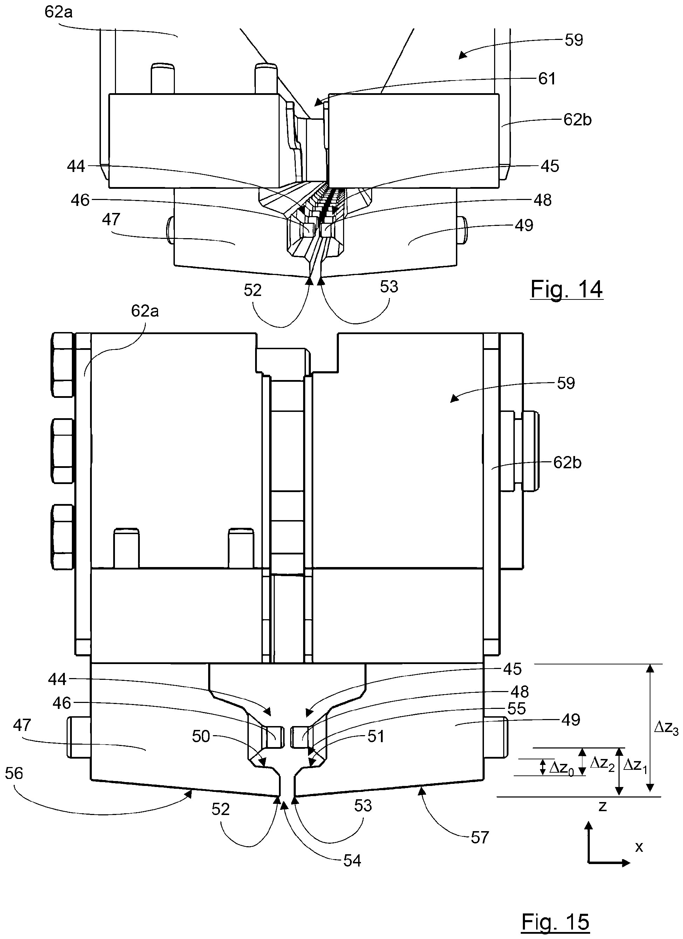

The engagement features of the first and second arrays 44,45 are located in the space 55 at a distance *Δz₁* (Fig. 15) in opposite direction *z* to the first direction -*z* from the edges 52,53. In particular, the engagement features of the first and second arrays 44,45 are located in the space 55 at a distance *Δz₂* in opposite direction *z* to the first direction -*z* from where the dimension of the space 55 in third direction *x* has decreased to an at least local minimum. Generally, this minimum will correspond to a dimension in the third direction *x* of the gap 54 between the edges 52,53, as in the illustrated second substrate holding device 41.

In a variant, the space 55 and gap 54 may also be bounded at at least one of two opposite ends in the second direction *y*. In the illustrated second substrate holding device 41, this is not the case.

The edges 52,53 are relatively sharply defined, in order to ensure that the liquid flows out of the gap 54 and onto the major surfaces of the substrate 1 with relatively few eddies. The first flow guide surface 50 meets a first exterior surface 56 at an angle at the first edge 52. The second flow guide surface 51 meets a second exterior surface 57 at an angle at the second edge 53. The angle may be equal to or smaller than 90°, for example. It is also possible to provide an undercut at the edges 52,53 to promote detachment of the flow from the bodies 47,49 at the edges 52,53 .

To provide such sharp edges 52,53, the process of manufacturing the first and second bodies 47,49 may comprise a machining process, as explained in relation to the first substrate holding device 3.

A flow distributor 58 separates a collecting space 59 from the space 55 for accommodating the edge region of the substrate 1. The flow distributor 58 is provided with straight elongate through-going channels 60 and a meandering through-going channel 61, all extending in the first direction -*z* between opposite surfaces of the flow distributor 58. These channels open into the space 55 for accommodating the edge region of the substrate 1. It is through them that the space 55 is accessible to liquid. The meandering channel 61 meanders in the second direction *y*. The meandering channel 61 allows liquid to pass at a relatively high rate without the need to provide many discrete channels. A variant may comprise multiple such meandering channels 61.

The collecting space 59 is bounded in the third direction *x* by dam walls 62a,b, in this case in the form of plates mounted to at least one of the flow distributor 58 and the upper member 42.

In an apparatus for wet-chemical treatment of the substrate 1, stationary systems for supplying processing liquid may direct one or more jets onto or into the second substrate holding device 41. For example, one or more jets may be projected onto an outward-facing surface section 63 (Fig. 11) of the upper member 42. Alternatively, a flow guidance plate like the flow guidance plate 34 of the first substrate holding device 3 may be provided.

In the illustrated second substrate holding device 41, the collecting space 59 is closed at opposite ends in the second direction *y*. The collecting space 59 is thus formed as the interior of a basin. Projecting sheet-shaped jets onto the second substrate holding device 41 is therefore not strictly necessary.

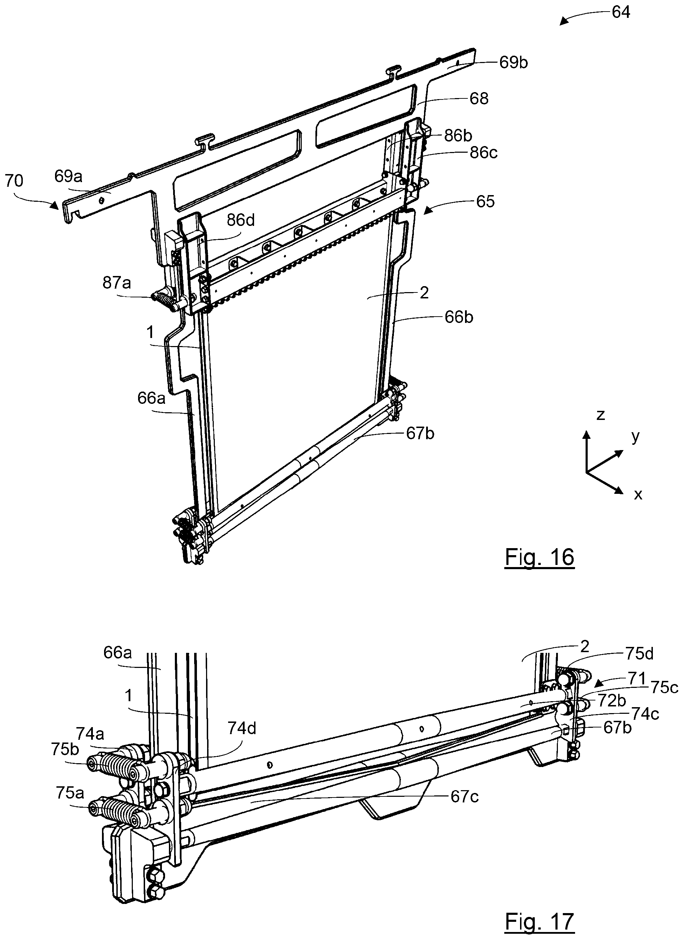

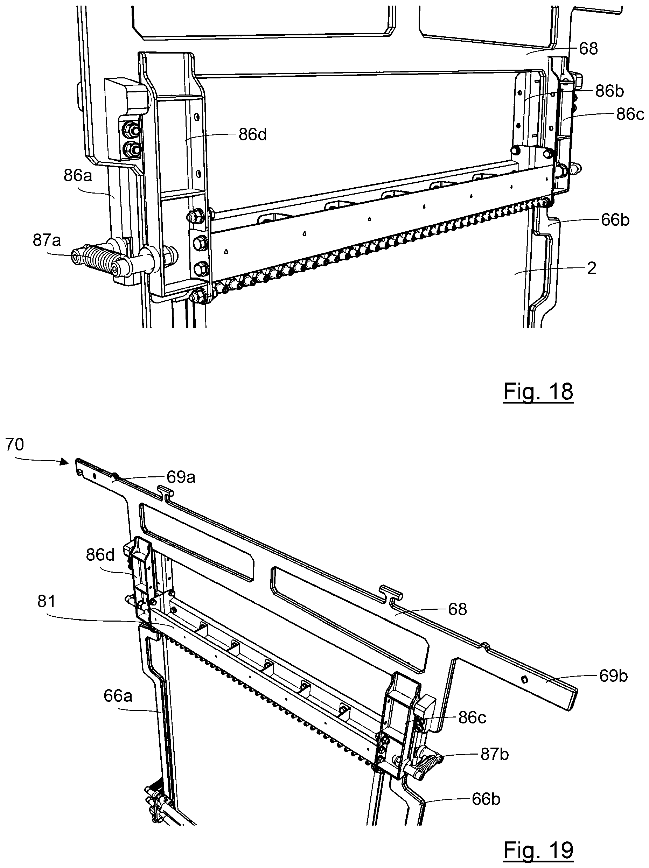

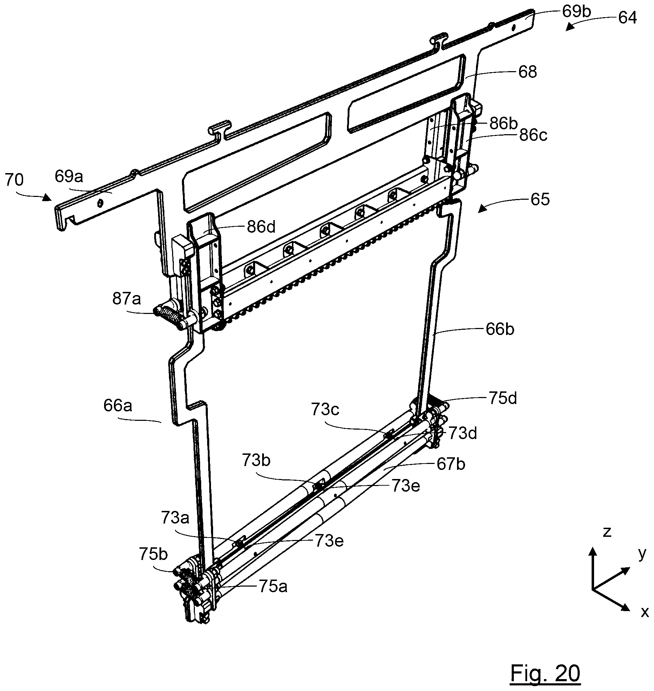

A third substrate holding device 64 (Figs. 16-25) is similar to the first substrate holding device 3, but configured for holding the substrate 1 and a further substrate 2 simultaneously. In particular, the substrate 1 and the further substrate 2 are held in parallel for simultaneous wet-chemical processing, in use.

The third substrate holding device 64 comprises a support structure for engaging an external support to position the third substrate holding device 64 in the apparatus for non-immersive wet-chemical treatment of the substrates 1,2. The support structure comprises a frame 65 arranged to frame at least a central section of a major surface of at least one of the substrates 1,2, seen looking onto that major surface. In the illustrated third substrate holding device 64, the frame 65 frames the substrates 1,2, at least seen looking onto the outward-facing major surface of each of the substrates 1,2.

The frame 65 comprises at least lateral members 66a,b, lower members 67a-c and an upper member 68.

The upper member 68 comprises laterally projecting arms 69a,b for engaging supports (not shown), so as to suspend the third substrate holding device 64 in a treatment station of the treatment apparatus. A claw 70 for engaging a horizontally extending pin of the support is defined at a distal end of at least one of the arms 69a,b. Examples of a suitable support are disclosed in WO 2020/260389 A1.

The same co-ordinate system is defined with reference to the substrates 1,2 when mounted to the third substrate holding device 64 with an orientation permitting the non-immersive wet-chemical treatment to be carried out. In that situation, the major surfaces of the planar substrates 1,2 are in planes parallel to a first direction -*z* and a second direction *y.* They face in directions aligned with a third direction *x*. In the orientation permitting non-immersive wet-chemical treatment to be carried out, the first direction -*z* is essentially aligned with the vertical, i.e. the planar substrates 12 have an upright orientation, so that liquid can flow down the major surfaces of the substrates 1,2 as a film flow.

The configuration of the support structure is such as to allow the third substrate holding device 64 to be conveyed from station to station in the treatment apparatus. To this end, the external support may either be comprised in a transporter of a conveying system (not shown) or the conveying station may be configured to transfer the third substrate holding device 64 between supports provided in respective treatment stations. At least one of the lower members 67a-e may be provided with one of at least one skid and at least one caster (not shown) for movably supporting the third substrate holding device 64 on a support surface.

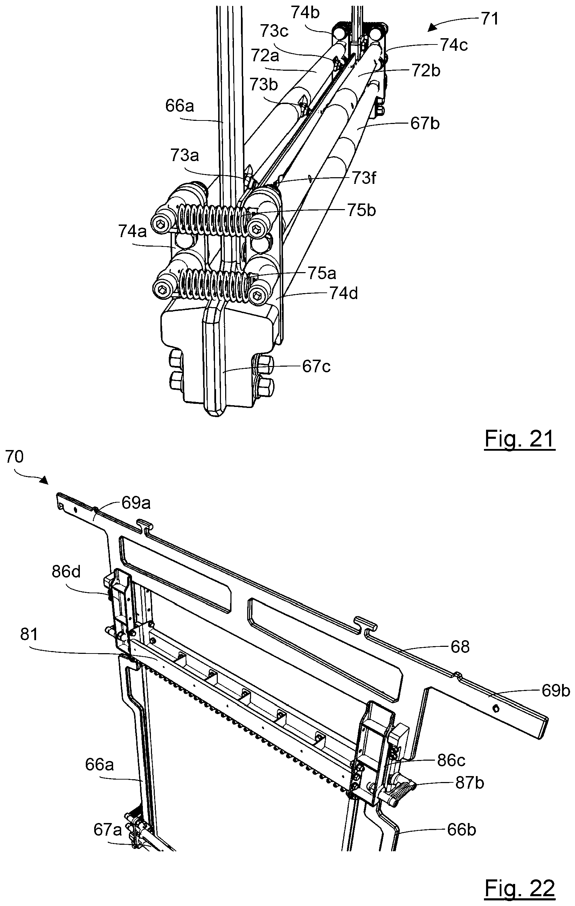

The third substrate holding device 64 comprises an upper clamping device (described in more detail below) and a lower clamping device 71 (Figs. 17, 21).

The lower clamping device 71 comprises a pair of support bars 72a,b on which protruding lower engagement features 73a-f are mounted. A central lower member 67c is positioned between the support bars 72a,b and provided with further protruding lower engagement features 73 (not shown in detail).

The central lower member 67c is a stationary with respect to the support structure, in this case being part of the frame 65. The central lower member 67c is in this example plate-shaped, but may have another shape. The plate-shape allows the substrates 1,2 to be positioned relatively closely together without restricting film flows across facing major surfaces of the substrates 1,2.

The central lower member 67c supports protruding engagement features on opposite sides of the central lower member 67c (with respect to the third direction *x*) and they protrude in opposite directions -*x*,*+x*. The lower engagement features 73a-f provided on the support bars 72a,b protrude towards the central lower member 67c. The lower engagement features 73a-f provided on one of the support bars 72a,b and those on a proximal side of the central lower member 67c are configured to engage the opposite major surfaces of one of the planar substrates 1,2 at an (in use lower) edge of the planar substrate 1,2. The lower engagement features 73a-f provided on the other of the support bars 72a,b and those on a proximal side of the central lower member 67c are configured to engage the opposite major surfaces of the other of the planar substrates 1,2 at an (in use lower) edge of that other planar substrate 1,2.

To this end, the support bars 72a,b are mounted on pivotable lower support levers 74a-d. Biasing devices comprising resilient elements, in this case lower coil springs 75a-d, are provided to urge the support bars 72a,b towards the central lower member 67c in the third direction *x*. Cams (not shown in detail) or other features may be defined on the lower support levers 74a-d to apply a force moving the support bars 72 apart in the third direction *x* to release the substrates 1,2.

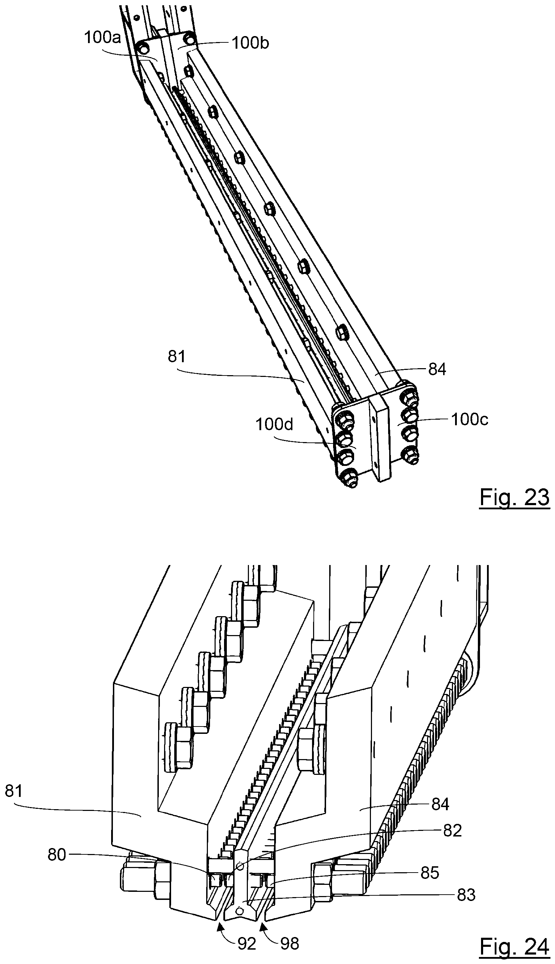

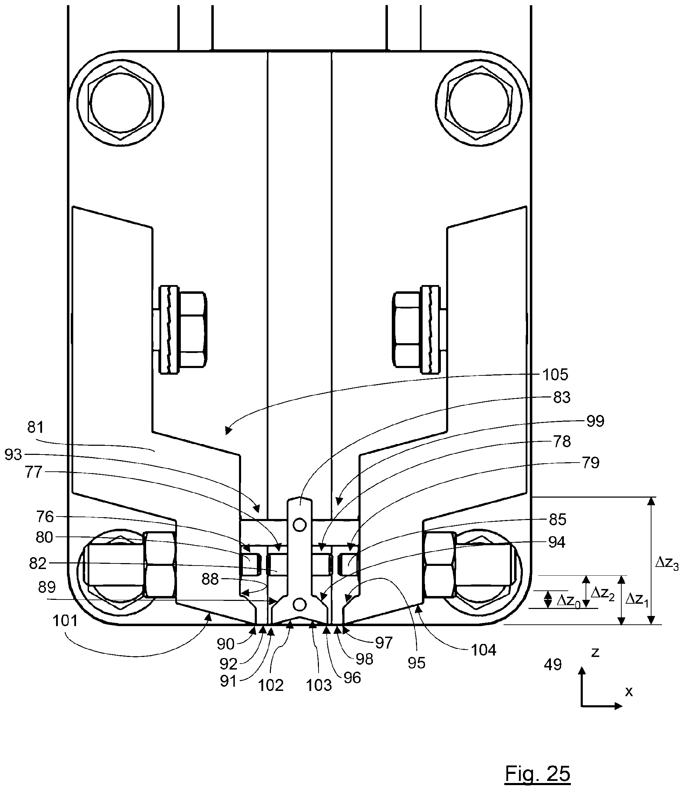

The upper clamping device comprises a first array 76 of engagement features and a second array 77 of engagement features for clamping the substrate 1 in an edge region close to an, in use upper, edge of the substrate 1 (Figs. 24, 25). The upper clamping device further comprises a third array 78 of engagement features and a fourth array 79 of engagement features for clamping the further substrate 2 in an edge region close to an, in use upper, edge of the further substrate 2.

The first array 76, second array 77, third array 78 and fourth array 79 extend in the second direction *y*. The engagement features of each array 76,77,78,79 are discrete features spaced apart in the second direction *y*. They protrude in directions corresponding to the third direction *x*, so that liquid can pass in the third direction -z between adjacent engagement features.

In the illustrated third substrate holding device 64, the engagement features of the first and second arrays 76,77 are in each case arranged in a single straight line, as are those of the third array 78,79. Alternatively, one or both arrays 76,77,78,79 forming a pair for clamping a substrate 1,2 may comprise multiple rows of engagement features, each row extending in the second direction *y,* with the rows spaced apart in the first direction *z.* The arrays, in the case of the alternative example the rows, may extend in non-straight, e.g. curved lines, e.g. if the edge region adjoins a curved substrate edge.

In the illustrated third substrate holding device 64, the engagement features of the first array 76 are formed by first pins 80 mounted to a first body 81. The engagement features of the fourth array 79 are formed by second pins 82 mounted to a third body 83. The first and third bodies 81,83 are essentially mirror images of each other and similar to the first and second bodies 19,20 of the first substrate holding device 3. Thus, the first and second pins 80,82 are provided with threads, mounted in respective bores or other through-going passages in the first and third body 81,83 and secured by first and second nuts or other means.

The engagement features of the second and third arrays 77,78 are supported on opposite sides with respect to the third direction *x* of a second body 84, and they protrude in the third direction *x* and an opposite direction -*x*, respectively.

In the illustrated third substrate holding device 64, the engagement features of the second and third arrays 77,78 are formed by opposite end sections of third pins 85 secured in respective bores or other through-going passages in the second body 84.

The second body 84 is mounted in fixed position with respect to the supporting structure. The first and third bodies 81,83 are mounted to pivotable upper support levers 86a-d, which are pivotably mounted to the support structure of the third substrate holding device 64. In this example, they are pivotably mounted to the upper member 68 of the frame 65. The pivot axes extend in the second direction *y*. Biasing devices comprising resilient elements, in this example upper coil springs 87a,b, are provided to urge the first and second arrays 76,77 towards each other and the third and fourth arrays 78,79 towards each other in a direction corresponding to the third direction *x*. These resilient elements thus provide the clamping force.

In a variant, the first and third bodies 81,83 or alternative supports carrying the first and fourth arrays 76,79, are themselves pivotably mounted to the support structure. In that case, they are thus only partially movable with respect each other, because their respective pivot axes are fixed in position.

The first body 81 presents an inward-facing surface comprising a first flow guide surface 88. The second body 84 presents a facing surface comprising a second flow guide surface 89. These surfaces are non-planar, but they are oriented parallel to the second direction /everywhere and parallel to or at an angle smaller than 90° to the first direction -*z*. Thus, the first flow guide surface 88 and the second flow guide surface 89 each progress in the first direction *-z* up to a first edge 90 and a second edge 91. There is a gap 92 between the first edge 90 and the second edge 91 through which an edge region of the substrate 1 can pass into a space 93 for accommodating the edge region. This space 93 is defined between at least sections of the facing surfaces of the first and second bodies 81,84, such that the first flow guide surface 88 and the second flow guide surface 89 are located on opposite sides of the space 93.

The dimension in the third direction *x* of the space 93 decreases at least over an interval *Δz₀* in the first direction -*z*. A gravitational flow of liquid flowing the first direction -*z* thus faces a constriction there. The liquid will back up.

The engagement features of the first and second arrays 76,77 are located in the space 93 at a distance *Δz₁* in opposite direction *z* to the first direction -*z* from the edges 90,91. In particular, the engagement features of the first and second arrays 76,77 are located in the space 93 at a distance *Δz₂* in opposite direction *z* to the first direction -*z* from where the dimension of the space 93 in third direction *x* has decreased to an at least local minimum91. Generally, this minimum will correspond to a dimension in the third direction *x* of the gap 92 between the edges 90,91, as in the illustrated example.

On an opposite side to the second flow guide surface 89 (with respect to the third direction *x*), the second body 84 presents a surface comprising a third flow guide surface 94. The third body 83 presents a facing surface comprising a fourth flow guide surface 95. These surfaces are non-planar, but they are oriented parallel to the second direction *y* everywhere and parallel to or at an angle smaller than 90° to the first direction -*z*. Thus, the third flow guide surface 94 and the fourth flow guide surface 95 each progress in the first direction *-z* up to a third edge 96 and a fourth edge 97. There is a further gap 98 between the third edge 96 and the fourth edge 97 through which an edge region of the further substrate 2 can pass into a further space 99 for accommodating the edge region. This further space 99 is defined between at least sections of the facing surfaces of the second and third bodies 84,83, such that the third flow guide surface 94 and the fourth flow guide surface 95 are located on opposite sides of the further space 99.

The dimension in the third direction *x* of the further space 99 decreases at least over an interval *Δz₀* in the first direction -*z*. A gravitational flow of liquid flowing the first direction -*z* thus faces a constriction there. The liquid will back up.

The engagement features of the third and fourth arrays 78,79 are located in the further space 99 at a distance *Δz₁* in opposite direction *z* to the first direction -*z* from the third and fourth edges 96,97. In particular, the engagement features of the third and fourth arrays 78,79 are located in the further space 99 at a distance *Δz₂* in opposite direction zto the first direction -*z* from where the dimension of the further space 99 in third direction *x* has decreased to an at least local minimum. Generally, this minimum will correspond to a dimension in the third direction *x* of the further gap 98 between the third and fourth edges 96,97, as in the illustrated example.

The space 93 and further space 99 are each accessible to liquid at a distance from the edges 90,91,96,97 in opposite direction *z* to the first direction -*z* at least equal to the distance *Δz₁* in opposite direction *z* to the first direction *-z* between the arrays 76-79 and the edges 90,91,96,97. In an alternative embodiment, liquid may enter one or both of the space 93 and the further space 99 at a location closer to the edges 90,91,96,97, but at a distance in opposite direction *z* to the first direction -*z* from where the dimension of the space 93 and further space 99 in third direction *x* has decreased to an at least local minimum, since a gravitational flow of liquid will in any case then back up.

In the illustrated third substrate holding device 64, a gravitational flow of liquid can simply flow down, first between the first and third bodies 81,84, then between the first and second bodies 81,84 and between second and third bodies 84,83.

Although not required, the space 93 and gap 92, as well as the further space 99 and further gap 98 are also bounded at at least one of two opposite ends in the second direction *y*. This helps keep the arrays 76-79 submerged, in use. In the illustrated third substrate holding device 64 end plates 100a-d similar to the end plates 30a,b of the first substrate holding device 3 are provided to bound the gap 92, the further gap 98, the space 93 and the further space 99.

The edges 90,91,96,97 are relatively sharply defined, in order to ensure that the liquid flows out of the gap 92 onto the major surfaces of the substrate 1 and out of the further gap 98 onto the major surfaces of the further substrate 2 with relatively few eddies. The first flow guide surface 88 meets a first exterior surface 101 at an angle at the first edge 90. The second flow guide surface 89 meets a second exterior surface 102 at an angle at the second edge 91. The third flow guide surface 94 meets a third exterior surface 103 at an angle at the third edge 96. The fourth flow guide surface 95 meets a fourth exterior surface 104 at an angle at the fourth edge 97.

The angle concerned may in each case be equal to or smaller than 90°, for example.

To provide such sharp edges 90,91,96,97 the process of manufacturing one or more of the first, second and third bodies 81,84,83 may comprise a machining process. The bodies 81,84,83 may be machined entirely from a respective block of material or the machining process may be applied to a pre-form, e.g. a pre-form obtained by moulding or additive manufacturing.

In an apparatus for wet-chemical treatment of the substrate 1 and further substrate 2, stationary systems for supplying processing liquid may direct one or more jets onto or into the third substrate holding device 64. For example, a flow guidance plate like the flow guidance plate 34 of the first substrate holding device 3 may be provided. In any case, because the second body 84 has a smaller dimension parallel to the first direction -*z* than the first and third bodies 81,83, a collecting space 105 is formed between facing surface sections of the first and third bodies 81,83 adjacent the space 93 and further space 99. It suffices to direct a single jet of processing liquid into that collecting space 105.

The invention is not limited to the embodiments described above, which may be varied within the scope of the accompanying claims. For example, the third substrate holding device 64 can be modified to hold even more further substrates by providing further bodies like the second body 84 between the first and third bodies 81,83. This is only possible due to the fact that the processing liquid contacts the edge region of the substrate 1 before passing through the gap 27,54,92, in use. Both major surfaces of each substrate 1,2 can still be processed relatively uniformly, including up to the edge next to the edge region.

Dedicated engagement feature supports may be provided to support the engagement features instead of the bodies presenting the flow guide surfaces.

### List of reference numerals

- 1 -: substrate
- 2 -: further substrate
- 3 -: first substrate holding device
- 4 -: frame
- 5a,b -: Lateral members
- 6a-c -: Lower member
- 7 -: Upper member
- 8a,b -: Projecting arms
- 9 -: claw
- 10 -: Lower clamping device
- 11a,b -: Support bar
- 12a-f -: Lower engagement features
- 13a-d -: Lower support levers
- 14a-d -: Lower coil springs
- 15 -: First array of engagement features
- 16 -: Second array of engagement features
- 17 -: First pins
- 18 -: Second pins
- 19 -: First body
- 20 -: Second body
- 21a-d -: Upper support levers
- 22a,b -: Upper coil springs
- 23 -: First flow guide surface
- 24 -: Second flow guide surface
- 25 -: First edge
- 26 -: Second edge
- 27 -: gap
- 28 -: Space
- 29 -: Baffle plate
- 30a-d -: End plates
- 31 -: First exterior surface
- 32 -: Second exterior surface
- 33a,b -: Outward-facing surface section
- 34 -: Flow guidance plate
- 35a,b -: Edge of flow guidance plate
- 36 -: First dam wall section
- 37 -: Second dam wall section
- 38 -: Collecting space
- 39 -: Flow distributor
- 40 -: Flow distributor aperture
- 41 -: Second substrate holding device
- 42 -: Upper member
- 43a,b -: Projecting arms
- 44 -: First array of engagement features
- 45 -: Second array of engagement features
- 46 -: First pin
- 47 -: First body
- 48 -: Second pin
- 49 -: Second body
- 50 -: First flow guide surface
- 51 -: Second flow guide surface
- 52 -: First edge
- 53 -: Second edge
- 54 -: Gap
- 55 -: Space
- 56 -: First exterior surface
- 57 -: Second exterior surface
- 58 -: Flow distributor
- 59 -: Collecting space
- 60 -: Straight channel
- 61 -: Meandering channel
- 62a,b -: Dam wall
- 63 -: Outward-facing surface section
- 64 -: Third substrate holding device
- 65 -: frame
- 66a,b -: Lateral members
- 67a-c -: Lower members
- 68 -: Upper member
- 69a,b -: Projecting arms
- 70 -: Claw
- 71 -: Lower clamping device
- 72a,b -: Support bar
- 73a-f -: Lower engagement features
- 74a-d -: Lower support levers
- 75a-d -: Lower coil springs
- 76 -: First array of engagement features
- 77 -: Second array of engagement features
- 78 -: Third array of engagement features
- 79 -: Fourth array of engagement features
- 80 -: First pin
- 81 -: First body
- 82 -: Second pin
- 83 -: Third body
- 84 -: Second body
- 85 -: Third pin
- 86a-d -: Upper support levers
- 87a,b -: Upper coil springs
- 88 -: First flow guide surface
- 89 -: Second flow guide surface
- 90 -: First edge
- 91 -: Second edge
- 92 -: Gap
- 93 -: Space
- 94 -: Third flow guide surface
- 95 -: Fourth flow guide surface
- 96 -: Third edge
- 97 -: Fourth edge
- 98 -: Further gap
- 99 -: Further space
- 100a-d -: End plates
- 101 -: First exterior surface
- 102 -: Second exterior surface
- 103 -: Third exterior surface
- 104 -: Fourth exterior surface
- 105 -: Collecting space

## Claims

1. Device for holding at least one planar substrate (1,2) in an apparatus for non-immersive wet-chemical treatment of the substrate (1,2), comprising:
a pair of flow guide surfaces (23,24;50,51;88,89) on opposite sides of a space (28;55;93) for accommodating an edge region of at least one substrate (1),
wherein the flow guide surfaces (23,24;50,51;88,89) extend in a first direction (-*z*) to respective edges (25,26;52,53;90,91) and extend in a second direction (*y*) transverse to the first direction (-*z*), and
wherein each of the edges (25,26;52,53;90,91) bounds a gap (27;54;92) for insertion of an edge region of at least one substrate (1) into the space (28;55;93), and
wherein a dimension of the space (28;55;93) in a third direction (*x*) transverse to the first and second directions (-*z*,*y*) decreases in the first direction (-*z*) over at least part (*Δz₀*) of an extent in the first direction (-*z*) of the space (28;55;93); and
at least one first array (15;44;76) of protruding engagement features and at least one second array (16;45;77) of protruding engagement features, protruding towards each other from first and second engagement feature supports (19;20;47;49;81;84), respectively,
wherein the first and second arrays (15,16;44,45;76,77) extend in the second direction (*y*), and
wherein the engagement feature supports (19;20;47;49;81;84) are at least partially movable with respect to each other to move the first and second arrays (15,16;44,45;76,77) in the third direction (*x*),
**characterised in that**
the protruding engagement features are located in the space (28;55;93) at a distance (*Δz₁*) from the
edges (25,26;52,53;90,91) in opposite direction (*z*) to the first direction (-*z*), and **in that**
the space (28;55;93) is accessible to liquid at a distance (*Δz₃*) from the edges (25,26;52,53;90,91) in opposite direction (*z*) to the first direction (-*z*).

2. Device according to claim 1,
wherein the space (28;93) is closed, e.g. bounded by walls (30a-d; 100a-d), at opposite ends in the second direction (*y*).

3. Device according to claim 1 or 2, further comprising
at least one flow distributor (39;58) having at least one channel (40;60,61) formed therein,
wherein the channels (40;60,61) extend in the first direction (-*z*), and
wherein the channels (40;60,61) open into the space (28;55;93) for accommodating the edge region of at least one substrate (1).

4. Device according to claim 3,
wherein the channels (40;60,61) comprise a plurality of discrete, e.g. straight channels (60).

5. Device according to claim 3 or 4,
wherein the channels (40;60,61) comprise at least one channel (61) open at opposite ends of the channel (61) in the first direction *(-z)* and having a shape meandering in the second direction (*y*).

6. Device according to any one of the preceding claims,
further comprising at least one biasing device, e.g. at least one resilient element (22;87), for urging the first and second engagement feature supports (19,20;81,84) towards each other in the third direction (*x*).

7. Device according to any one of the preceding claims,
wherein the flow guide surfaces (23,24;50,51;88,89) are formed on respective first and second bodies (19;20;47;49;81;84), and
wherein at least one of the first and second feature supports corresponds to a respective one of the first and second bodies (19;20;47;49;81;84).

8. Device according to claim 7,
wherein the engagement features protruding from the engagement feature support forming a respective one of the first and second bodies (19;20;47;49;81;84) each comprise a section of a respective pin (17,18;46,48;80,82) fixed to that body (19;20;47;49;81;84).

9. Device according to claim 7 or 8,
wherein the engagement features protruding from the engagement feature support forming a respective one of the first and second bodies (19;20;47;49;81;84) protrude from the flow guide surface (23,24;50,51;88,89) formed on that body (19;20;47;49;81;84).

10. Device according to any one of the preceding claims, further comprising
a support structure (4;65) comprising at least one part (8,9;43;69,70) for engaging an external support to position the device in the apparatus for non-immersive wet-chemical treatment of the substrate (1,2).

11. Device according to claim 10,
wherein at least one of the first and second engagement feature supports (19;20;47;49;81;84) is journalled to the support structure (4;65).

12. Device according to any one of the preceding claims, further comprising
a third array (78) of protruding engagement features and a fourth array (79) of protruding engagement features, protruding towards each other from respective engagement feature supports (84,83),
wherein each of the third and fourth arrays (78,79) extends in the second direction (*y*), and
wherein the engagement feature supports (83,84) are at least partially movable with respect to each other to move the third and fourth arrays (78,79) in the third direction,
wherein the engagement features of the third and fourth arrays (78,79) are one of:
(i) located in the space (28;55;93) for accommodating the edge region of at least one substrate (1) at a distance from the edges (25,26;52,53;90,91) in opposite direction (*z*) to the first direction (-*z*), and
(ii) located in a second space (99) for accommodating the edge region of at least one substrate (2),
wherein a second pair of second flow guide surfaces (94,95) is provided on opposite sides of the second space (99),
wherein the second flow guide surfaces (94,95) extend in the first direction (-*z*) to respective second edges (96,97) and extend in the second direction (*y*), and
wherein each of the second edges (96,97) bounds a second gap (98) for insertion of an edge region of at least one substrate (2) into the second space (99), and
wherein a dimension of the second space (99) in the third direction (*x*) decreases in the first direction (-*z*) over at least part (*Δz₀*) of an extent in the first direction (-*z*) of the second space (99),
wherein the protruding engagement features of the third and fourth arrays (78,79) are located in the second space (99) at a distance (*Δz₁*) from the second edges (96,97) in opposite direction (*z*) to the first direction (-*z*), and
wherein the second space (99) is accessible to liquid at a distance (*Δz₃*) from the second edges (96,97) in opposite direction (*z*) to the first direction (-*z*).

13. Device according to claim 12,
wherein one of the third array (78) of protruding engagement features and the fourth array (79) of protruding engagement features protrudes from one of the first and second engagement feature supports (81,84) in an opposite direction to the engagement features of that one of the first and second arrays (76,77) protruding from that one of the first and second engagement feature supports (81,84).

14. Apparatus for non-immersive wet-chemical treatment of at least one planar substrate (1,2), comprising:
at least one treatment station;
at least one device (3;41;64) according to any one of the preceding claims;
at least one support to hold the device (3;41;64) in the treatment station; and
at least one liquid supply system for supplying liquid to the space (28;55;93) for accommodating the edge region of at least one substrate (1,2) in at least the treatment station.

15. Method of non-immersive wet-chemical treatment of a planar substrate (1,2), e.g. in an apparatus according to claim 14, comprising:
mounting the substrate (1,2) to a device (3;41;64) according to any one of claims 1-13, and
supplying processing liquid to the space (28;55;93) for accommodating an edge region of at least one substrate (1,2).
